# EUROPÄISCHE PATENTSCHRIFT

(11) **EP 1 284 024 B1**
(45) Veröffentlichungstag und Bekanntmachung des Hinweises auf die Patenterteilung: **11.02.2015**
(21) Anmeldenummer: 01935953.8
(22) Anmeldetag: 06.04.2001
(51) Int. Cl.: H01L 33/38, H01L 33/42

(54) **BAUELEMENT FÜR DIE OPTOELEKTRONIK**
OPTOELECTRONIC COMPONENT
COMPOSANT DESTINE AU DOMAINE OPTOELECTRONIQUE

(30) Priorität: 23.05.2000 DE 10025448; 15.02.2001 DE 10107472
(43) Veröffentlichungstag der Anmeldung: 19.02.2003
(73) Patentinhaber: OSRAM Opto Semiconductors GmbH, 93055 Regensburg (DE)
(72) Erfinder: BAUR, Johannes, 93180 Deuerling (DE); STRAUSS, Uwe, 93077 Bad Abbach (DE); LINDER, Norbert, 93173 Wenzenbach (DE); SEDLMEIER, Reinhard, 93073 Neutraubling (DE); NIRSCHL, Ernst, 93173 Wenzenbach (DE)
(74) Vertreter: Epping - Hermann - Fischer
(86) Internationale Anmeldenummer: PCT/DE2001/001369
(87) Internationale Veröffentlichungsnummer: WO 2001/091194

(56) Entgegenhaltungen:
- EP-A- 0 083 510
- EP-A- 0 977 277
- EP-A1- 0 921 577
- DE-A- 19 927 945
- US-A- 3 202 543
- PATENT ABSTRACTS OF JAPAN vol. 018, no. 617 (E-1634), 24. November 1994 (1994-11-24) -& JP 06 237012 A (NICHIA CHEM IND), 23. August 1994 (1994-08-23)
- PATENT ABSTRACTS OF JAPAN vol. 1998, no. 14, 31. Dezember 1998 (1998-12-31) -& JP 10 256602 A (SHARP CORP), 25. September 1998 (1998-09-25)

## Beschreibung

Die Erfindung betrifft ein Bauelement für die Optoelektronik mit einer Strahlung hindurchlassenden Kontaktfläche auf einer Halbleiteroberfläche auf der Basis von InₓAl_{y}Ga_{1-x-y}N mit 0 ≤ x ≤ 1,0 ≤ y ≤ 1 und x + y ≤ 1.

In epitaktisch gewachsenen Lumineszenzdioden, die auf dem Materialsystem InAlGaN beruhen, liegt die laterale Stromaufweitung in der p-dotierten Schicht im Bereich von wenigen Zehnteln *µ*m bis wenigen *µ*m. Daher ist es üblich, für die Anschlußkontakte ganzflächige Kontaktschichten auf der Halbleiteroberfläche aufzubringen, um eine gleichmäßige Strominjektion in die aktive Schicht der Lumineszenzdiode zu gewährleisten. Diese flächig aufgebrachten Kontaktschichten absorbieren jedoch einen beträchtlichen Teil des durch die Halbleiteroberfläche austretenden Lichts.

Bisher wurden für die Anschlußkontakte sehr dünne, semitransparente Kontaktschichten verwendet. Derartige semitransparente Kontaktschichten auf einem Halbleiterchip auf der Basis von InAlGaN sind aus der US 5,767,581 A bekannt. Um eine hohe Transparenz der Anschlußkontakte zu gewährleisten, müssen die semitransparenten Schichten möglichst dünn ausgebildet werden. Dem steht die Forderung nach ausreichender Homogenität, ausreichender Querleitfähigkeit und niedrigem Kontaktwiderstand entgegen. Die für herkömmliche Lumineszenzdioden verwendeten semitransparenten Kontaktschichten absorbieren daher zwangsweise einen Großteil des durch die Oberfläche austretenden Lichts.

Bei hoher thermischer Belastung können darüber hinaus die bekannten optoelektronischen Bauelemente auf der Basis von InAlGaN mit semitransparenten Kontakten aufgrund einer Degradation der Kontaktschicht ausfallen.

Aus der DE 1 99 27 945 A1 ist ferner bekannt, auf die p-dotierte Schicht einer Lumineszenzdiode auf der Basis von InAlGaN eine Kontaktschicht mit einer Dicke von 100 bis 3000 nm aufzubringen. In dieser Kontaktschicht sind Öffnungen mit einer Weite von 0,5 bis 2 *µ*m eingebracht, um eine verbesserte Lichttransmission durch die Kontaktschicht zu ermöglichen.

EP0921577 offenbart ein optoelektronisches Halbleiterbauelement mit einer strahlungsemittierenden Mehrschichtstruktur auf der Basis von InAlGaN und einer Kontaktschicht mit einer Dicke von 700 nm, wobei die Kontaktschicht eine Vielzahl von nebeneinander angeordneten Öffnungen aufweist.

Ausgehend von diesem Stand der Technik liegt der Erfindung die Aufgabe zugrunde, für die Optoelektronik geeignete Bauelemente auf der Basis von InAlGaN mit verbesserter Lichtauskopplung zu schaffen.

Diese Aufgabe wird erfindungsgemäß durch ein Bauelement gemäß Anspruch 1 gelöst.

Durch das Vorsehen einer Vielzahl von Ausnehmungen in der Kontaktschicht wird die Lichtauskopplung wesentlich erhöht. Denn an den Stellen, an denen die Kontaktschicht geschwächt oder unterbrochen ist, wird mehr Licht hindurchtreten als an den Stellen, an denen die Kontaktschicht die volle Dicke aufweist. Da die Kontaktschicht nur lokal geschwächt und unterbrochen ist,ist trotz der verbesserten Lichtauskopplung der Kontaktschicht die gleichmäßige Injektion in die aktive Schicht des optischen Bauelements gewährleistet.

Außerdem sind die Ausnehmungen vorteilhaft für das Alterungsverhalten des optoelektronischen Bauelements. Denn eine p-dotierte Schicht aus InAlGaN enthält geringe Mengen an Was-serstoff, der beim Betrieb des optoelektronischen Bauelements zur Grenzfläche zwischen der Kontaktschicht und der Schicht aus InAlGaN diffundiert. Falls die Kontaktschicht nicht durchlässig für Wasserstoff ist, sammelt sich dieser an der Grenzfläche an und passiviert den Dotierstoff. Daher steigt bei thermischer Belastung der Kontaktwiderstand zwischen der Kontaktschicht und der darunterliegenden Schicht aus InAlGaN an. Thermische Belastungen treten sowohl im Betrieb der fertigen Lumineszenzdioden als auch bei der Prozessierung der Wafer auf. Über die geschwächten Stellen in der Kontaktschicht kann jedoch der Wasserstoff entweichen und der Kontaktwiderstand bleibt im wesentlichen konstant.

In diesem Zusammenhang ist auch die Schichtdicke der Kontaktschicht von Bedeutung. Denn um den Abtransport des Wasserstoffs zu gewährleisten, ist es von Vorteil, wenn die Breite der Stege zwischen den Ausnehmungen möglichst klein ist. Um für einen niedrigen Kontaktwiderstand die Grenzfläche zwischen der Kontaktschicht und der p-dotierten Schicht möglichst groß zu machen, soll eine große Zahl von Ausnehmungen vorhanden sein, deren Querschnittsabmessungen in der Größenordnung der Wellenlänge des vom Bauelement emittierten Lichts liegen. Dann durch eine große Zahl von Ausnehmungen mit geringen Querschnittsabmessungen kann der Wasserstoff gleichmäßig über die Fläche hinweg aus der darunterliegenden Schicht aus InAlGaN entweichen. Die Dicke der Kontaktschicht sollte jedoch ein Vielfaches unter den minimalen Querschnittsabmessungen der Ausnehmungen liegen, damit eine große Zahl von dicht nebeneinanderliegenden Ausnehmungen strukturgenau in der Kontaktschicht ausgebildet werden kann, ohne daß die Stege der Kontaktschicht Ätzschäden erleidet, die ihre Fähigkeit zum Stromtransport beeinträchtigen.

Bei einer bevorzugten Ausführungsform sind die Ausnehmungen Öffnungen, die durch die Kontaktschicht hindurchgehen.

Bei dieser Ausführungsform wird der Wasserstoff um die Kontaktschicht herumgeleitet und kann ungehindert aus der unter der Kontaktschicht liegenden Schicht aus InAlGaN entweichen.

Die Kontaktschicht wird mittels einer Lage von die Halbleiteroberfläche unvollständig bedeckenden Teilchen mit Ausnehmungen strukturiert.

Die auf die Halbleiteroberfläche angebrachten Teilchen dienen als Maske für die nachfolgende Strukturierung der Kontaktfläche. Vom besonderen Vorteil ist, daß zu diesem Zweck keine aufwendige Photo- oder Elektronenstrahl-Lithographie angewandt werden muß.

Weitere zweckmäßige Ausgestaltungen der Erfindung sind Gegenstand der abhängigen Ansprüche.

Im folgenden wird die Erfindung im einzelnen anhand der beigefügten Zeichnung erläutert. Es zeigen:
- Figur 1: einen Querschnitt durch ein Ausführungsbeispiel eines optoelektronischen Bauelements;
- Figur 2: eine Aufsicht auf ein optoelektronische Bauelement aus Figur 1;
- Figur 3: einen Querschnitt durch ein zweites Ausführungsbeispiel eines optoelektronischen Bauelements;
- Figur 4: eine Aufsicht auf das optoelektronische Bauelement aus Figur 3;
- Figur 5a bis 5c: verschiedene Querschnittsprofile von in der Kontaktschicht der optoelektronischen Bauelemente eingebrachten Ausnehmungen;
- Figur 6a bis 6c: verschiedene Verfahrensschritte zum Aufbringen von Kügelchen auf einen Wafer zur Herstellung der Ausnehmungen in der Kontaktschicht des optoelektronischen Bauelements;
- Figur 7: eine Aufsicht auf ein abgewandeltes Ausführungsbeispiel des optoelektronischen Bauelements, und
- Figur 8a bis 8d: verschiedene aus Schlitzen zusammengesetzte Öffnungen in der Kontaktschicht des optoelektronischen Bauelements.

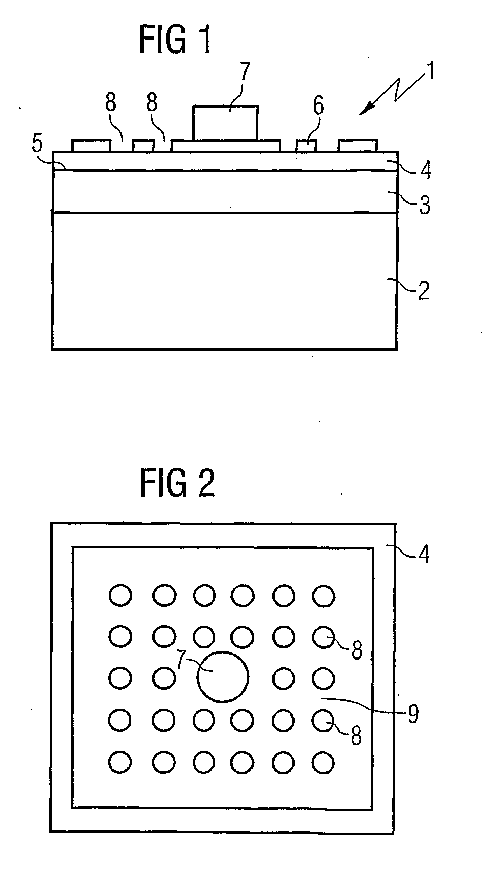

Figur 1 zeigt einen Querschnitt durch eine Lumineszenzdiode 1, die ein leitfähiges Substrat 2 aufweist. Auf das Substrat 2 ist eine n-dotierte Schicht 3 aufgebracht, an die sich eine p-dotierte Schicht 4 anschließt. Sowohl die n-dotierte Schicht 3 als auch die p-dotierte Schicht 4 sind auf der Basis von InAlGaN hergestellt. Dies bedeutet, daß sich die n-dotierte Schicht 3 und die p-dotierte Schicht 4 bis auf herstellungsbedingte Verunreinigungen und die Zugabe von Dotierstoffen eine Zusammensetzung gemäß der Formel:

InₓAl_{y}Ga_{1-x-y}N

aufweisen, wobei 0 ≤ x ≤ 1, 0 ≤ y ≤ 1 und x + y ≤ 1 gilt.

Zwischen n-dotierter Schicht 3 und p-dotierter Schicht 4 entsteht ein pn-Übergang 5, in dem bei Stromfluß Photonen entstehen. Um den Stromfluß über den pn-Übergang 5 zu ermöglichen, ist eine Kontaktschicht 6 auf der p-dotierten Schicht 4 vorgesehen, an der ein Anschlußkontakt 7 angebracht ist. Unter dem Begriff Kontaktschicht soll in diesem Zusammenhang eine Schicht verstanden werden, die zu einer angrenzenden Schicht aus einem halbleitenden Material einen Ohmschen Kontakt herstellt. Der Begriff Ohmsche Kontakt soll die in der Haltleiterphysik übliche Bedeutung haben.

Da es sich bei der Lumineszenzdiode 1 um eine Lumineszenzdiode handelt, die auf der Basis des Materialsystems InAlGaN hergestellt ist, liegt die laterale Stromaufweitung in der p-dotierten Schicht 4 im Bereich weniger Zehntel *µ*m bis weniger *µ*m. Daher erstreckt sich die Kontaktschicht 6 möglichst ganzflächig über die p-dotierte Schicht 4, um eine gleichmäßige Stromverteilung über den pn-Übergang 5 zu gewährleisten. Damit andererseits die im pn-Übergang 5 erzeugten Photonen möglichst absorptionsfrei aus der Lumineszenzdiode 1 austreten können, sind in der Kontaktschicht 6 Öffnungen 8 ausgebildet. Die Querschnittsabmessung der Öffnungen 8 sind so gewählt, daß sie kleiner als das Doppelte der lateralen Stromaufweitung in der p-dotierten Schicht 2 sind. Je nach Dicke der p-dotierten Schicht 4 liegt die laterale Stromaufweitung in der p-dotierten Schicht 4 auf der Basis von InAlGaN zwischen 1 und 4 *µ*m.

Andererseits soll verhindert werden, daß sich beim Betrieb der Lumineszenzdiode 1 Wasserstoff aus der p-dotierten Schicht 4 entlang der Grenzfläche zu der Kontaktschicht 6 anreichert und dort den Dotierstoff, üblicherweise Magnesium, passiviert, denn dies hätte einen bei thermischer Belastung auftretenden Anstieg des Kontaktwiederstands an der Grenzfläche zwischen der Kontaktschicht 6 und der p-dotierten Schicht 4 zur Folge. Es ist daher von Vorteil, wenn eine möglichst große Zahl von Öffnungen in der Kontaktschicht 6 ausgebildet sind, um den Wasserstoff aus der p-dotierten Schicht 4 möglichst gleichmäßig über die Fläche hinweg abzuführen. Es besteht daher die Tendenz, eher eine große Zahl von Öffnungen 8 mit kleinen Querschnittsabmessungen vorzusehen. Die Querschnittsabmessungen der Öffnungen 8 werden daher vorzugsweise kleiner 3 *µ*m, insbesondere kleiner 1 *µ*m gewählt. Falls insbesondere die Öffnungen 8 kreisförmig ausgebildet sind, wird der Durchmesser der Öffnungen 8 kleiner 3 *µ*m, vorzugsweise kleiner 1 *µ*m gewählt. Um andererseits eine ausreichend hohe Lichtauskopplung durch die Kontaktschicht 6 hindurch zu erhalten, sollten die Querschnittsabmessungen der Öffnungen 8 oberhalb von 1/4 der Wellenlänge der von der Lumineszenzdiode 1 erzeugten Photonen in den Öffnungen 8 liegen. Die Querschnittsabmessungen der Öffnungen 8 sollten daher mindestens 50 nm betragen.

Falls nicht allzu hohe Anforderungen an die Durchlässigkeit der Kontaktschicht 6 gestellt werden, können die Öffnungen 8 durch Vertiefungen in der Kontaktschicht 6 ersetzt werden. In diesem Fall sollte die verbleibende Materialstärke jedoch so gering sein, daß die in dem pn-Übergang 5 erzeugten Photonen durch die Kontaktschicht 6 austreten können. Zudem muß gewährleistet sein, daß der Wasserstoff durch das verbleibende Material hindurchtreten kann. Dies ist insbesondere dann der Fall, wenn das verbleibende Material für Wasserstoff durchlässig ist. Derartige Materialien sind zum Beispiel Palladium oder Platin.

Darüber hinaus ist es auch möglich, die Kontaktschicht 6 selbst so dünn auszubilden, daß die Kontaktschicht 6 für Photonen semitransparent und für Wasserstoff durchlässig ist.

Figur 2 zeigt eine Aufsicht auf die Lumineszenzdiode 1 aus Figur 1. Aus Figur 2 geht hervor, daß die Öffnungen 8 gleichmäßig beabstandet über die Fläche der Kontaktschicht 6 verteilt sind. Um die ohmschen Verluste beim Stromtransport vom Anschlußkontakt 7 zu den Randbereichen der Kontaktschicht 6 hin gering zu halten, kann die Dichte der Öffnungen 8 nach außen hin zunehmen, so daß in der Nähe des Anschlußkontakts 7 breite Kontaktstege 9 vorhanden sind. Im übrigen ist es auch möglich, die Querschnittsfläche der Öffnungen 8 zu den Rändern der Kontaktschicht 6 hin anwachsen zu lassen. Auch diese Maßnahme dient dazu, einen möglichst effizienten Stromtransport vom Anschlußkontakt 7 zu den Rändern der Kontaktschicht 6 zu gewährleisten.

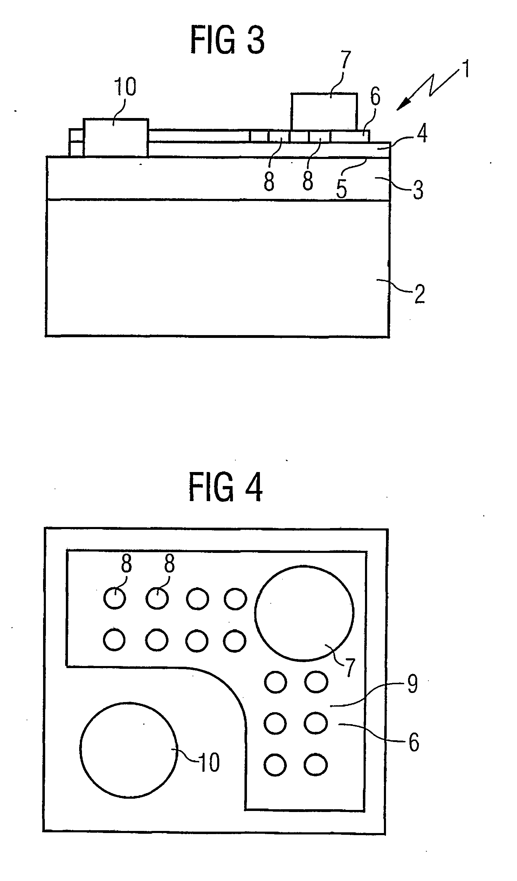

In Figur 3 ist ein weiteres Ausführungsbeispiel der Lumineszenzdiode 1 dargestellt. Bei diesem Ausführungsbeispiel ist das Substrat 2 isolierend ausgebildet. Dementsprechend ist ein weiterer Anschlußkontakt 10 für die n-dotierte Schicht 3 vorgesehen. Dementsprechend deckt die p-dotierte Schicht 4 und die Kontaktschicht 6 nur einen Teil der n-dotierten Schicht 3 ab. Dies ist insbesondere anhand von Figur 4 deutlich zu erkennen.

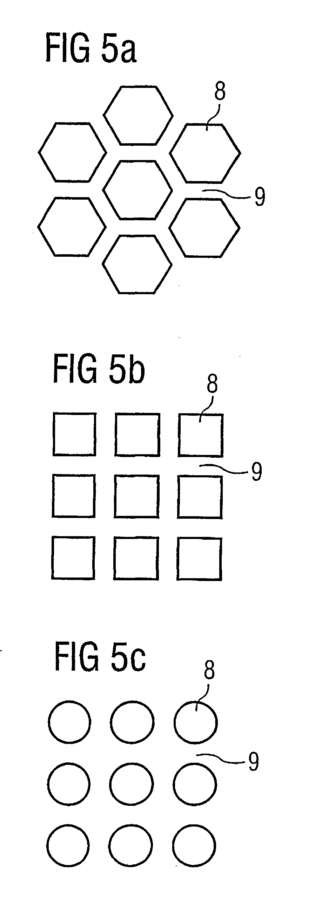

Figur 5a bis 5c zeigen schließlich verschiedene Ausführungsformen der Öffnungen 8. Insbesondere die in Figur 5a dargestellte hexagonale Querschnittsform der Öffnungen 8 bietet Vorteile, da diese Ausführungsform ein besonders hohes Verhältnis von offener zu überdeckter Fläche aufweist. Aber auch quadratische oder kreisförmige Querschnittsflächen der Öffnungen 8 sind denkbar. Falls die Öffnungen 8 quadratisch oder rechteckig ausgebildet sind, weist die Kontaktschicht 6 über die Fläche hinweg eine netzartige Gestalt auf.

Die Herstellung der Öffnungen 8 erfolgt mit den üblichen lithographischen Verfahren. Um Schäden an der n-dotierten Schicht 3, der p-dotierten Schicht 4 und dem Substrat 2 zu vermeiden, sind geeignete Kombinationen von für die Kontaktschicht 6 und den Anschlußkontakt 10 verwendeten Kontaktmetallen und Ätzverfahren zu verwenden. Insbesondere das mit cyanidhaltigen Ätzen naßchemisch ätzbare Palladium eignet sich für die Kontaktschicht 6. Daneben kommt auch Platin in Frage. Im Falle von durchgehenden Öffnungen 8 kann die Kontaktschicht 6 auch aus Materialien hergestellt sein, die an sich für Wasserstoff nicht durchlässig sind. Derartige Materialien sind zum Beispiel Ag oder Au sowie Legierungen hiervon. Es ist auch denkbar, für die Kontaktschicht 6 eine Schicht aus Pt oder Pd mit einer darauf aufgebracht weiteren Schicht aus Au vorzusehen.

Für den Ätzvorgang eignen sich grundsätzlich sowohl naßchemische Ätzverfahren als auch Reaktives Ionen-Ätzen oder Rücksputtern. Unabhängig vom Ätzverfahren sollte die Dicke der Kontaktschicht 6 möglichst unterhalb von 100 nm liegen, damit die Stege der Kontaktschicht 6 nicht durch den Ätzvorgang beschädigt wird, so daß die Fähigkeit zum gleichmäßigen Stromtransport leidet. Das Problem tritt insbesondere dann auf, wenn eine besonders große Zahl von Öffnungen 8 mit einem Durchmesser unterhalb von 3 *µ*m, insbesondere 1 *µ*m, in der Kontaktschicht 6 ausgebildet werden soll. Denn in diesem Fall kommt es besonders darauf an, daß die zwischen den Öffnungen 8 vorhandenen Stege der Kontaktschicht 6 möglichst unversehrt bleiben, um einen sicheren Stromtransport zu gewährleisten. Eine große Zahl von Öffnungen 8 in der Kontaktschicht 6 mit einem Durchmesser unterhalb von 3 *µ*m, insbesondere 1 *µ*m ist aber besonders günstig, um den Wasserstoff aus der p-dotierten Schicht 4 gleichmäßig über die Kontaktschicht 6 hinweg abzuführen.

Weiterhin spricht für eine Dicke von weniger als 100 nm die Einstellung der Ätztiefe. Um das vollständige Ausätzen der Öffnungen 8 zu gewährleisten, ist es im allgemeinen erforderlich, die Ätzzeit so zu wählen, daß die Ätztiefe im Material der Kontaktschicht 6 beispielsweise mehr als 10% über der Dicke der Kontaktschicht 6 liegt. Wenn aber die Ätzrate der p-dotierten Schicht größer als die Ätzrate der Kontaktschicht 6 ist, kann es bei Schichtdicken oberhalb von 100 nm für die Kontaktschicht 6 vorkommen, daß unterhalb der Öffnungen 8 in der Kontaktschicht 6 die p-dotierte Schicht 4 vollkommen weggeätzt wird. Es ist daher von Vorteil, die Kontaktschicht 6 nicht dicker als 100 nm werden zu lassen.

Bei besonders strengen Anforderungen an die Genauigkeit des Ätzvorgangs sollte die Dicke der Kontaktschicht 6 unterhalb von 50 nm, vorzugsweise 30 nm liegen.

Insbesondere bei naßchemischen Ätzverfahren tritt zusätzlich das Problem des Hinterätzens der als Maske verwendeten Photolackschicht auf. Dies hat zur Folge, daß sich Strukturen mit einer Strukturgröße im Bereich von 1 *µ*m nur dann sicher ätzen lassen, wenn die Dicke der zu ätzenden Kontaktschicht wesentlich kleiner ist als die Strukturgröße ist.

Für besonders kleine Öffnungen 8 in der Kontaktschicht 6 eignet sich insbesondere das Rücksputtern mit Argon-Ionen. Dabei beträgt die Ätzrate jedoch nur etwa 5 nm pro Minute. Bei einer Dicke der Kontaktschicht 6 oberhalb von 100 nm wird die Ätzzeit so lang, daß der als Maske verwendete Photolack nur schwer von der Oberfläche der Kontaktschicht 6 entfernt werden kann.

Es sei angemerkt, daß beim Ätzen der Öffnungen 8 in der Kontaktschicht 6 auch gezielt Vertiefungen in die p-dotierte Schicht 4 eingeätzt werden können. Diese Vertiefungen können auch linsenartig ausgeführt werden. Durch die entstehenden schrägen Flanken oder rauhen Oberflächen kann die Lichtauskopplung zusätzlich verbessert werden.

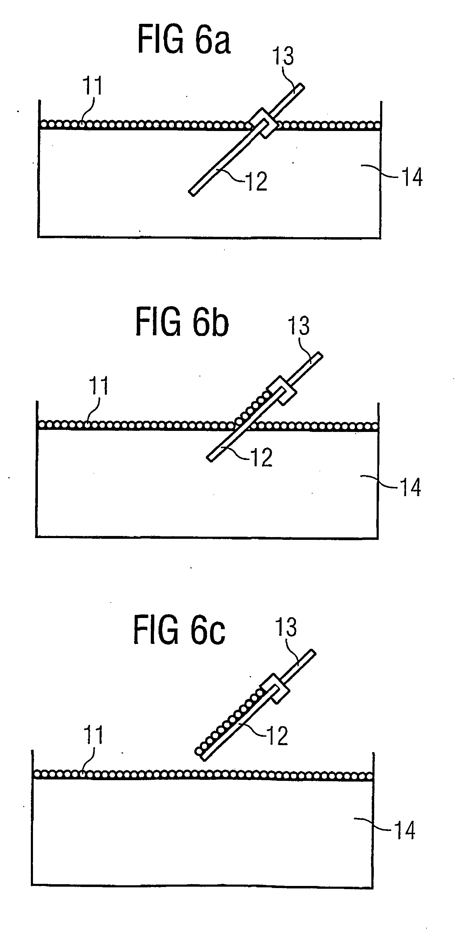

Zur Herstellung der Öffnungen 8 können, wie in Fig. 6a bis c dargestellt, auch kleine Kügelchen 11, beispielsweise aus Polystyrol mit Durchmessern unter 1 *µ*m verwendet werden. Dieses Verfahren hat den Vorteil, daß damit auch Öffnungen 8 in der Kontaktschicht 6 ausgebildet werden können, die zu klein sind, um mit der üblichen Phototechnik und den üblichen Ätzverfarhen hergestellt zu werden. Dazu wird ein Wafer 12 mit der Lumineszenzdiode 1 mit Hilfe einer Haltevorrichtung 13 in eine Flüssigkeit 14 eingetaucht, auf deren Oberfläche eine einzelne Lage der aufzubringenden Kügelchen 11 schwimmt. Die Dichte der Kügelchen 11 auf der p-dotierten Schicht 4 wird durch die Dichte der Kügelchen 11 auf der Flüssigkeitsoberfläche bestimmt. Durch Zufügen einer Base kann die Oberflächenspannung der Flüssigkeit reduziert werden und die Bildung von Agglomeraten verhindert werden. Der Wafer 12 wird vollständig eingetaucht und anschließend langsam herausgezogen. Die Kügelchen 11 haften dann auf der Oberfläche der p-dotierten Schicht 4 an. Die statistische Verteilung der Kügelchen 11 auf der Oberfläche der p-dotierten Schicht 4 ist insofern von Vorteil, als dadurch Interferenzeffekte beim Durchstrahlen der Kontaktschicht 6 vermieden werden. Zur Vermeidung von Interferenzeffekten beim Durchstrahlen der Kontaktschicht 6 kann eine statistische Mischung von Kügelchen mit unterschiedlichen Kugeldurchmessern verwendet werden.

Es ist jedoch auch möglich, die Kügelchen 11 so auf der Oberfläche der p-dotierten Schicht 4 zu verteilen, daß die Dichte der Kügelchen 11 zu den Rändern der p-dotierten Schicht 4 hin zunehmen.

Um bei hoher Bedeckungsdichte der Oberfläche der p-dotierten Schicht 4 mit Kügelchen die Berührungspunkte zwischen den Kügelchen aufzuheben, können in einem weiteren Verfahrensschritt die Radien der Kügelchen beispielsweise durch Plasmaätzen in ionisiertem Sauerstoff verringert werden, so daß zwischen den Kügelchen freie Stege entstehen, durch die die Oberfläche der p-dotierten Schicht 4 bedampft werden kann. Durch das Bedampfen mit einem geeigneten Metall entsteht dann eine zusammenhängende Kontaktschicht 6.

Bei einer Variante des nicht beanspruchten Verfahrens wird zunächst die Kontaktschicht 6 auf die p-dotierte Schicht 4 aufgedampft und danach die vollständige Monolage der Kügelchen 11 auf die Kontaktschicht 6 aufgebracht. Anschließend wird die Kontaktschicht 6 in freibleibenden Bereichen durch Rücksputtern oder Plasmaätzen entfernt.

Schließlich werden die Kügelchen 11 auf mechanischen Wege, beispielsweise mit einem Lösungsmittel in einem Ultraschallbad, oder auf chemischen Wege, beispielsweise durch Auflösen der Kugeln in einer Ätzlösung, entfernt.

Es sei angemerkt, daß zum Aufbringen der Kügelchen 11 eine Haftschicht auf der Oberfläche der p-dotierten Schicht 4 verwendet werden kann, die vor dem Bedampfen der freibleibenden Oberfläche entfernt wird.

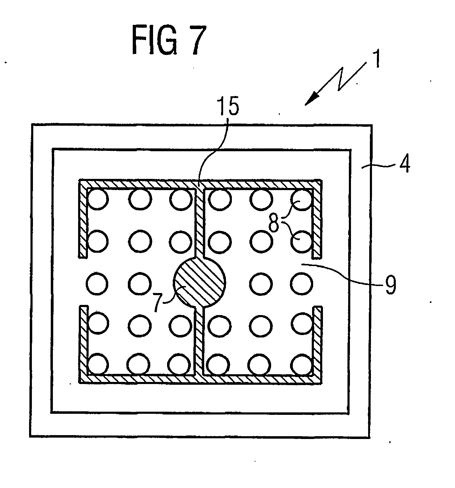

Um den Spannungsabfall an der Kontaktschicht 6 möglichst gering zu halten, ist bei dem in Figur 7 dargestellten Ausführungsbeispiel auf der Kontaktschicht 6 eine Leiterbahn 15 ausgebildet, durch die die Verteilung des Stroms in der Kontaktschicht 6 erleichtert wird.

Dies zeigen auch die nachfolgend beschriebenen Messungen. Für diese Messungen wurde eine Lumineszenzdiode 1 auf der Basis von InGaN auf einem Substrat 2 aus SiC verwendet. Die Emissionswellenlänge der Lumineszenzdiode 1 lag bei 460 nm. Die Größe der Lumineszenzdiode 1 betrug 260 x 260 *µ*m. Der Anschlußkontakt 7 war aus Au gefertigt und wies eine Dicke von 1 *µ*m und einen Durchmesser von 100 *µ*m auf. Die Kontaktschicht 6 aus Pt war 6 nm dick. Die Lumineszenzdioden 1 wurden in einem Gehäuse eingebaut und bei einer Strombelastung von 20 mA vermessen. Eine Lumineszenzdiode mit flächendeckender, transparenter Kontaktschicht diente als Referenz.

Gegenüber dieser Lumineszenzdiode wies die Lumineszenzdiode 1 mit der in Figur 2 dargestellten Struktur der Kontaktschicht 6 eine um 5% bessere Lichtleistung auf. Allerdings war die Vorwärtsspannung um 30 mV höher. Die höhere Vorwärtsspannung ist eine Folge der im Vergleich zur Referenz geringeren Querleitung der Kontaktschicht 6.

Die Lumineszenzdiode mit der durch die Leiterbahn 15 verstärkten Kontaktschicht 6 wies gegenüber der Referenz eine um 3% bessere Lichtleistung auf. Außerdem war die Vorwärtsspannung 50 mV niedriger. Das in Figur 7 dargestellte Ausführungsbeispiel erwies sich daher als besonders vorteilhaft.

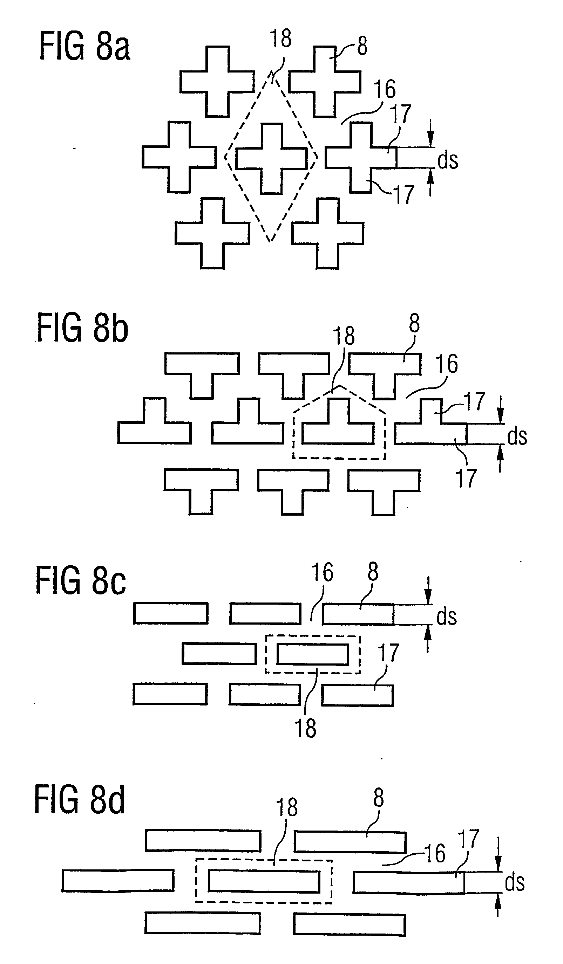

Die Figuren 8a bis 8d zeigen eine weitere Abwandlung der Öffnungen 8 in der Kontaktschicht 6. Die in den Figuren 8a bis 8d dargestellten Öffnungen setzen sich aus langgestreckten Schlitzen zusammen und sind so angeordnet, daß die zwischen den Öffnungen 8 vorhandenen Stege 16 eine netzartige Struktur bilden, deren Maschen die Öffnungen 8 bilden.

Die in Figur 8a dargestellten Öffnungen 8 weisen ein kreuzförmiges Querschnittsprofil auf. In diesem Fall sind die Öffnungen 8 von jeweils zwei überkreuzt angeordneten Schlitzen 17 gebildet. Die Schlitze 17 weisen jeweils eine Breite d_{S} auf, die der doppelten lateralen Stromaufweitung in der p-dotierten Schicht 4 entspricht. Der Abstand zwischen den Öffnungen 8 ist so gewählt, daß die zwischen den Öffnungen 8 verbleibenden Stege 16 noch eine ausreichende Leitfähigkeit aufweisen, um den Strom über die Kontaktschicht 6 hinweg zu verteilen. Außerdem ist darauf zu achten, daß die Grenzfläche zwischen der Kontaktschicht 6 und der darunter liegenden p-dotierten Schicht 4 nicht zu klein wird, damit der Kontaktwiderstand zwischen der Kontaktschicht 6 und der darunter liegenden p-dotierten Schicht 4 nicht zu groß wird. Als günstig hat sich eine Anordnung erwiesen, in der der minimale Abstand zwischen den Öffnungen 6 größer als die Breite d_{S} der Öffnungen 8 ist. Aus der Betrachtung einer Elementarzelle 18 ergibt sich dann ein Bedeckungsgrad für die Kontaktschicht 6 von 58%. Die Öffnungen 8 nehmen also in diesem Fall 43% der Fläche der Kontaktschicht 6 ein.

Es ist auch denkbar, wie in Figur 8b dargestellt, T-förmige Öffnungen 8 vorzusehen oder, wie in Figur 8c dargestellt, die Öffnungen 8 als rechteckige Schlitze 17 auszubilden. Im Falle der Öffnungen 8 aus Figur 8b ergibt sich ein Bedeckungsgrad der Kontaktschicht 6 von 60%; bei dem in Figur 8c dargestellten Ausführungsbeispiel sogar ein Bedeckungsgrad von 61%. Der Bedeckungsgrad läßt sich jedoch stark vermindern, wenn die Schlitze 17 zunehmend verlängert werden. Der geringste Bedekkungsgrad, nämlich 50%, ergibt sich, wenn die Kontaktschicht 6 entsprechend Figur 8c und Figur 8d als Liniengitter strukturiert wird. Allerdings besteht hier die Gefahr, daß große Teile des pn-Übergangs 5 von der Stromversorgung abgeschnitten werden, wenn einer der Kontaktstege 16 unterbrochen wird. Daher ist die in Figur 8a dargestellte Gestaltung der Öffnungen 8 bseonders vorteilhaft, da sie neben einer hohen Betriebssicherheit auch einen hohen Öffnungsgrad aufweist.

Im übrigen wurden auch Versuche unternommen, die die Auswirkung der Struktur der Kontaktschicht 6 auf das Alterungsverhalten der Lumineszenzdiode 1 zeigt. Für diese Versuche wurde auf einem Substrat aus SiC eine n-dotierte Schicht 3 aus Al-GaN und GaN abgeschieden. Auf dieser Schicht wrude mit Hilfe von MOCVD eine mit Hilfe von Mg p-dotierte Schicht aufgebracht. Auf dem gleichen Wafer wurden auf den einzelnen Chips verschiedene Kontaktschichten 6 auf der p-dotierten Schicht 4 ausgebildet. Die Querschnittsabmessungen der Kontaktschichten 6 lagen zwischen 200 *µ*m x 200 *µ*m und 260 *µ*m x 260 *µ*m. Um das Alterungsverhalten der Lumineszenzdioden 1 zu simulieren, wurden die Chips für die Leuchtdioden 1 bei einer Temperatur von 300°C während 20 Minuten getempert.

Ein erster Chip für die Lumineszenzdiode 1, dessen semitransparente Kontaktschicht aus Pt eine Dicke von 20 nm aufwies, hatte im Rahmen der Meßgenauigkeit bis auf +/- 20 mV vor und nach dem Tempern die gleiche Vorwärtsspannung.

Ein weiterer Chip für die Lumineszenzdiode 1 war mit einer Kontaktschicht 6 versehen, die aus Pt hergestellt war und eine Dicke von 20 nm aufwies. Zusätzlich war die Kontaktschicht 6 dieses Chips netzartig strukturiert mit einer Maschenöffnung von 3 *µ*m und einer Breite der verbleibenden Stege der Kontaktschicht 6 von ebenfalls 3 *µ*m. Auch dieser Chip hatte bis auf die Meßgenauigkeit von +/- 20 mV vor und nach dem Tempern die gleiche Vorwärtsspannung.

Das gleiche Alterungsverhalten zeigte auch ein Chip, dessen Kontaktschicht 6 sich halbleiterseitig aus einer ersten 6 nm dicken Schicht aus Pt und einer weiteren 20 nm dicken Schicht aus Au zusammensetzt und dessen Kontaktschicht ebenfalls netzartig strukturiert war.

Ein Anstieg um durchschnittlich 200 mV zeigten dagegen Chips für die Lumineszenzdiode 1, die mit ganzflächigen Kontaktschichten 6 ausgestattet waren, die sich halbleiterseitig aus einer 6 nm dicken Schicht aus Pt und einer weiteren 100 nm dicken Schicht aus Au zusammensetzten.

Diese Versuche zeigen, daß es für ein stabiles Alterungsverhalten wesentlich darauf ankommt das der Wasserstoff über die Kontaktschicht 6 entweichen kann. Dabei ist es nicht nötig, daß das für die Kontaktschicht 6 verwendete Material selbst für Wasserstoff durchlässig ist, sofern nur die Öffnungen 8 in der Kontaktschicht 6 ausgebildet sind.

Abschließend sei angemerkt, daß die hier vorgestellte Verbesserung der Lichtausbeute durch Schwächung der Kontaktschicht auch bei Laserdioden, insbesondere bei VCSELS eintritt. Es ist daher auch von Vorteil bei Laserdioden eine lokal geschwächte Kontaktfläche vorzusehen.

### Bezugszeichenliste

- 1: Lumineszenzdiode
- 2: Substrat
- 3: n-dotierte Schicht
- 4: p-dotierte Schicht
- 5: pn-Übergang
- 6: Kontaktschicht
- 7: Anschlußkontakt
- 8: Öffnungen
- 9: Kontaktsteg
- 10: Anschlußkontakt
- 11: Kügelchen
- 12: Wafer
- 13: Haltvorrichtung
- 14: Flüssigkeit
- 15: Leiterbahn
- 16: Stege
- 17: Schlitz
- 18: Elementarzelle

## Patentansprüche

1. Bauelement für die Optoelektronik mit einer Kontaktschicht (6) auf einer Halbleiteroberfläche auf der Basis von InₓAl_{y}Ga_{1-x-y}N mit 0 ≤ x ≤ 1, 0 ≤ y ≤ 1 und x + y ≤ 1, wobei die Kontaktschicht (6) eine Vielzahl von nebeneinander angeordneten Ausnehmungen (8) aufweist,
**dadurch gekennzeichnet,**
**daß** die Kontaktshicht (6) eine Strahlung hindurchlassende Kontaktschicht ist und daß die Dicke der Kontaktschicht (6) größer 5 nm und kleiner 100 nm ist.

2. Bauelement nach Anspruch 1,
**dadurch gekennzeichnet,**
**daß** die Summe der Querschnittsflächen der Ausnehmungen (8) größer als die Fläche der verbleibenden Kontaktschicht (6) ist.

3. Bauelement nach Anspruch 1 oder 2,
**dadurch gekennzeichnet,**
**daß** die Querschnittsflächen der Ausnehmungen (8) kreisförmig sind.

4. Bauelement nach Anspruch 1 oder 2,
**dadurch gekennzeichnet,**
**daß** die Ausnehmungen (8) sechseckige Querschnittsflächen aufweisen.

5. Bauelement nach Anspruch 1 oder 2,
**dadurch gekennzeichnet,**
**daß** die Ausnehmungen (8) von langgestreckten Schlitzen (17) gebildet sind.

6. Bauelement nach Anspruch 5,
**dadurch gekennzeichnet,**
**daß** die Stege (16) zwischen den Ausnehmungen (8) vernetzt sind.

7. Bauelement nach einem der Ansprüche 1 bis 6,
**dadurch gekennzeichnet,**
**daß** die Ausnehmungen (8) gleichmäßig beabstandet über die Kontaktschicht (6) verteilt sind.

8. Bauelement nach einem der Ansprüche 1 bis 6,
**dadurch gekennzeichnet,**
**daß** die Ausnehmungen (8) ungleichmäßig beabstandet über die Kontaktschicht (6) verteilt sind.

9. Bauelement nach einem der Ansprüche 1 bis 6,
**dadurch gekennzeichnet,**
**daß** die Querschnittsfläche der Ausnehmungen (8) zum Rand der Kontaktschicht (6) hin zunimmt.

10. Bauelement nach einem der Ansprüche 1 bis 9,
**dadurch gekennzeichnet,**
**daß** die Ausnehmungen durch die Kontaktschicht (6) hindurchgehende Öffnungen (8) sind.

## Claims

1. Component for optoelectronics comprising a contact layer (6) on a semiconductor surface on the basis of InₓAl_{y}Ga_{1-x-y}N where 0 ≤ x ≤ 1, 0 ≤ y ≤ 1 and x + y ≤1, wherein the contact layer (6) has a multiplicity of cutouts (8) arranged alongside one another,
**characterized**
**in that** the contact layer (6) is a radiation-transmissive contact layer, and in that the thickness of the contact layer (6) is greater than 5 nm and less than 100 nm.

2. Component according to Claim 1,
**characterized**
**in that** the sum of the cross-sectional areas of the cutouts (8) is greater than the area of the remaining contact layer (6).

3. Component according to Claim 1 or 2,
**characterized**
**in that** the cross-sectional areas of the cutouts (8) are circular.

4. Component according to Claim 1 or 2,
**characterized**
**in that** the cutouts (8) have hexagonal cross-sectional areas.

5. Component according to Claim 1 or 2,
**characterized**
**in that** the cutouts (8) are formed by elongated slots (17).

6. Component according to Claim 5,
**characterized**
**in that** the webs (16) between the cutouts (8) are interlinked.

7. Component according to any of Claims 1 to 6,
**characterized**
**in that** the cutouts (8) are distributed in a manner spaced apart uniformly over the contact layer (6).

8. Component according to any of Claims 1 to 6,
**characterized**
**in that** the cutouts (8) are distributed in a manner spaced apart non-uniformly over the contact layer (6).

9. Component according to any of Claims 1 to 6,
**characterized**
**in that** the cross-sectional area of the cutouts (8) increases towards the edge of the contact layer (6).

10. Component according to any of Claims 1 to 9,
**characterized**
**in that** the cutouts are openings (8) through the contact layer (6).

## Revendications

1. Composant pour l'optoélectronique, comprenant une couche de contact (6) sur une surface semi-conductrice à base de InₓAlyGa_{1-x-y}N, avec 0 ≤ x ≤ 1, 0 ≤ y ≤ 1, et x + y ≤ 1, la couche de contact (6) présentant une pluralité d'évidements (8) disposés les uns à côté des autres,
**caractérisé en ce que**
la couche de contact (6) est une couche de contact transparente au rayonnement et **en ce que** l'épaisseur de la couche de contact (6) est supérieure à 5 nm et inférieure à 100 nm.

2. Composant selon la revendication 1,
**caractérisé en ce que**
la somme des surfaces en section transversale des évidements (8) est supérieure à la surface de la couche de contact restante (6).

3. Composant selon la revendication 1 ou 2,
**caractérisé en ce que**
les surfaces en section transversale des évidements (8) sont circulaires.

4. Composant selon la revendication 1 ou 2,
**caractérisé en ce que**
les évidements (8) présentent des surfaces en section transversale hexagonales.

5. Composant selon la revendication 1 ou 2,
**caractérisé en ce que**
les évidements (8) sont formés par des fentes allongées (17).

6. Composant selon la revendication 5,
**caractérisé en ce que**
les nervures (16) entre les évidements (8) sont interconnectées.

7. Composant selon l'une quelconque des revendications 1 à 6,
**caractérisé en ce que**
les évidements (8) sont répartis de manière espacée uniformément sur la couche de contact (6).

8. Composant selon l'une quelconque des revendications 1 à 6,
***caractérisé en ce que**
les évidements (8) sont répartis de manière espacée non uniformément sur la couche de contact (6).

9. Composant selon l'une quelconque des revendications 1 à 6,
**caractérisé en ce que**
la surface en section transversale des évidements (8) augmente jusqu'au bord de la couche de contact (6).

10. Composant selon l'une quelconque des revendications 1 à 9,
**caractérisé en ce que**
les évidements sont des ouvertures (8) traversant la couche de contact (6).
